# EUROPEAN PATENT SPECIFICATION

(11) **EP 3 611 291 B1**
(45) Date of publication and mention of the grant of the patent: **04.10.2023**
(21) Application number: 17911084.6
(22) Date of filing: 27.11.2017
(51) Int. Cl.: C23C 16/517, C23C 16/455, C23C 16/511, C23C 16/515, B05D 1/00, B05D 5/08

(54) **METHOD FOR PREPARING MULTI-FUNCTIONAL PROTECTIVE NANO COATING BY MEANS OF CYCLICAL LARGE-DUTY-RATIO PULSE DISCHARGE**
VERFAHREN ZUR HERSTELLUNG EINER MULTIFUNKTIONSNANOSCHUTZBESCHICHTUNG MITTELS ZYKLISCHER PULSENTLADUNG MIT GROSSEM TASTVERHÄLTNIS
PROCÉDÉ DE PRÉPARATION D'UN NANOREVÊTEMENT PROTECTEUR MULTIFONCTIONNEL AU MOYEN D'UNE DÉCHARGE D'IMPULSION CYCLIQUE À FACTEUR DE MARCHE ÉLEVÉ

(30) Priority: 21.05.2017 CN 201710360382
(43) Date of publication of application: 19.02.2020
(73) Proprietor: Jiangsu Favored Nanotechnology Co., Ltd., Donghuan Rd., Yuqi Industrial Park Wuxi Jiangsu 214183 (CN)
(72) Inventor: ZONG, Jian, Jiangsu 214183 (CN)
(74) Representative: Bayramoglu et al.
(86) International application number: PCT/CN2017/113191
(87) International publication number: WO 2018/214449

(56) References cited:
- WO-A1-2014/078488
- CN-A- 1 265 714
- CN-A- 102 821 873
- CN-A- 106 622 824
- CN-A- 107 177 835
- CN-A- 107 201 510
- CN-A- 107 201 511
- CN-A- 107 217 243
- DE-A1- 10 317 208
- US-A1- 2012 308 762

## Description

### TECHNICAL FIELD

The present invention belongs to the technical field of plasma chemical vapor deposition, and more particularly, the present invention relates to a method for preparing a multi-functional nano coating for protection.

### BACKGROUND

Corrosive environment is the most common factor for damages to electronic devices. Environmental corrosion gives rise to the corrosion of solid materials, degradation of insulation performance of conductors/semiconductors, and failure phenomena, such as short circuit, open circuit or poor contact, in electronic devices. At present, among products in high-tech industries such as national defense and aerospace, electronic parts account for an increasingly great share, and the requirements on properties of electronic products, such as moisture resistance, mould resistance and corrosion resistance, are becoming increasingly strict. While in the field of communications, the requirements on heat dissipation of communication devices and stability and reliability of signal transmission have become higher and higher along with the continuous technical progress and continuous increase of communication frequencies. Thus, a reliable method is needed for providing effective protection for circuit boards and electronic elements, while not affecting normal heat dissipation and signal transmission.

Characterized by economic efficiency, easy application and a wide range of applications, polymer coating is usually used for protection of material surfaces, and it can provide good physical and chemical durability for various materials; based on the barrier property of polymer coating, a protective film formed on the surface of electronic products and circuit boards can effectively isolate circuit boards and protect circuits from corrosion and damages in a corrosive environment, thereby improving the reliability of electronic devices, enhancing their safety factors and ensuring their service lives. As such, polymer coating is used as an anticorrosive coating.

Conformal coating is a technological process during which a specific material is applied on PCB to form an insulation protective layer that is of the same shape as that of the coated object. As a common waterproof method for circuit boards, conformal coating can effectively isolate circuit boards and protect circuits from corrosion and damages under adverse environments. There are also some problems and drawbacks with current preparation processes of conformal coating: solvents in the liquid phase method tend to cause damages to circuit board devices; the high temperature for heat curing of coatings tends to cause damages to devices; it is hard for photo-cured coating to reach the interior of closed devices. Union Carbide Co. in the U.S.A. developed and applied a new conformal coating material. Parylene coating is a polymer of p-xylene. Featured by low moisture and gas permeability and high barrier effect, it is moisture proof, water proof, rust proof, and acid and alkali resistant. It has been found through research that poly-p-xylylene is produced through deposition in a vacuum state and it can be applied in the fields where liquid coating cannot be involved, such as the protection of high frequency circuits and extremely weak current systems. The thickness of a polymer film coating is the main reason that causes the protection by a conformal coating formed by vapor deposition of poly-p-xylylene to fail, and in the case that the thickness of a polymer film coating on a printed circuit board assembly is within a range of 3-7 micrometers, localized rust tends to occur and the coating fails to provide protection. The thickness of coating should be equal to or greater than 30 micrometers, provided that high frequency dielectric loss is not affected. Parylene coating has relatively high requirements for the pretreatment of printed circuit boards to be protected For conducting assemblies, signal transmission assemblies, and radio frequency assemblies ,masking pretreatment needs to be performed on circuit board assemblies at the time of vapor disposition to form a conformal coating so as to avoid impacts on properties of the assemblies. This disadvantage greatly restricts the application of Parylene coating. It is hard to widely apply Parylene coating because of costly raw materials for preparation thereof, strict conditions for the coating preparation (requirements of high temperature and high vacuum degree) and low film forming speed. In addition, a thick coating tends to give rise to issues like poor heat dissipation, signal blocking, more coating defects.

Plasma chemical vapor deposition (PCVD) is a technology that uses plasma to activate reaction gases, to facilitate chemical reactions on a substrate surface or in a space near a surface, and to generate solid films. Coatings formed with PCVD have the following advantages:
(1) It is a dry process, and films formed are even without pinholes.
(2) Plasma polymer films have stable chemical and physical properties, such as solvent resistance, chemical resistance, heat resistance and wear resistance.
(3) Plasma polymer films can be well bonded to a substrate.
(4) A uniform thin film can also be formed on an extremely uneven and irregular substrate surface.
(5) The temperature for coating preparation is low, which can be carried out at normal temperature, thereby effectively avoiding damages to temperature sensitive devices.
(6) The plasma technology not only can be used for the preparation of coating with a micrometer-level thickness, but also can be used for the preparation of ultrathin nano coating.

By use of the chemical vapor deposition technology, P2i Company in the U.K. developed a polymer nano coating by using a method based on a specific low duty ratio pulse discharge, and the low duty ratio is lower than 1: 1000. However, the preparation process of the method based on the specific low duty ratio pulse discharge cannot realize an effective combination and control between the energy provided and bond lengths and bond energies of different groups in raw chemical materials or molecular weights of the materials. Moreover, the scratch resistance and durability of the prepared coating are not ideal. Limited by the properties of this coating, only a lyophobic nano coating can be formed on electronic and electrical devices at present, which cannot effectively provide resistance to a corrosive environment. Furthermore, the compact protective coating prepared with the method based on a specific low duty ratio pulse discharge has fatal defects: from a microscopic angle, a low power density during a coating process is not conductive to the formation of compact structures, and may even be unable to form stable film structures; from a macroscopic angle, a low power density is not conductive to the high speed growth of coating, and the efficiency is low in actual production, which limits its application.

In existing preparation processes of plasma chemical vapor deposition coating, substrates are always fixed, and there is no relation between the movement state of a substrate and the plasma discharge energy; a continuous discharge method is used to process the static substrate in a chamber, and under the action of continuous discharge, activated broken chains in monomers usually combine into a film through simple piling. The obtained coating usually has a loose structure and high pulverization degree, which is not conductive to the formation of micro compact structure of the coating. Thus, the coating has poor protective properties, such as water resistance, moisture resistance, corrosion resistance and solvent resistance.

Since the plasma and raw chemical materials have different densities in different regions of a reaction chamber, and the substrate remains motionless, the coating deposition velocity is slow in some areas, which leads to a low production efficiency. Moreover, there is a phenomenon that uniformity and compactness are significantly different.

Relevant prior art documents include US 2012/308762 A1 (LEGEIN FILIP [BE] ET AL) 6 December 2012.

WO 2014/078488 A1 (LIQUIPEL IP LLC [US]) 22 May 2014.

CN 106 622 824 A (WUXI RJ IND CO LTD) 10 May 2017.

### SUMMARY

In order to solve the technical issues mentioned above, the present invention provides a method for cyclically preparing a multi-functional nanocoating for protection through high duty ratio pulse discharge. In the preparation process, the technology mainly consists of pretreatment and coating phases. In the pretreatment phase, the plasma discharge mode is high power continuous discharge; in the coating phase, the discharge mode of plasmas is high duty ratio pulse discharge. Moreover, the pretreatment and coating phases are at least repeated for 2 times to form a multi-layer compact structure. Kinetic characteristics of substrate and plasma discharge energy interact with each other. The substrate keeps in the movement state at the time when the plasma outputs discharge energy. Additional cross-linking points are introduced to form a cross-linked structure by introducing other monomer components with a poly-functional cross-linked structure through the plasma energy. Plasmas are generated through the plasma discharge, and through the control over the relationship between the plasma discharge energy and the bond energy of monomers, low temperature plasmas can effectively activate active groups with high energy in the monomer components so as to obtain active sites; and in the meanwhile, the introduced additional active sites are cross-linked and polymerized with each other in the plasma environment to form a compact mesh structure.

The technical solution that the present invention adopts is according to the appended claims.

The purpose of the pretreatment phase is to activate the substrate surface and form lots of active sites on the substrate surface. This bombardment pretreatment not only can remove impurities from the substrate surface, but also can activate the substrate surface, thus it is conductive to the coating deposition and improving the binding force between the coating and the substrate. During the pretreatment and coating processes that are repeated for multiple times, the bombardment process of the high power pretreatment after each coating can further form many active sites on the coating film surface and activate the surface of a coating layer, which is favorable for the further deposition of the coating and improves the binding force between the coating layers, thereby forming a multilayer coating structure with higher binding force and compactness. Compared with an ordinary single and long-time coating, the binding force and compactness are improved by at least 20%-40% and 15%-30%, respectively. This cyclic coating method through low power continuous discharge is significantly effective and very practical.

In the pretreatment phase, the plasma discharge mode is high power (120-400 W) continuous discharge, while in the coating phase, the plasma discharge mode is high duty ratio pulse discharge, the power is 50-200 W, the time is 600 s-3600 s, the pulse frequency is 1-1000 Hz, and the pulse duty ratio is 1:1-1: 1000. The plasmas generated during the continuous plasma discharge and deposition have an etching effect on the deposition film; in the coating phase, the high duty ratio pulse discharge combined with the kinetic characteristics of the substrate is conductive to speeding up the chemical deposition, and compared with the existing low duty ratio pulse discharge technology, the high duty ratio pulse discharge mode can form thicker and more compact films within a certain period of time, and the coating efficiency is higher. Thus, it can solve the fatal weakness of the compact protective coating prepared by P2i Company in the U.K. with the method based on a specific low duty ratio (the duty ratio is lower than 1: 1000) pulse discharge.

The components of the monomer vapor are:
a mixture of at least one mono-functional unsaturated fluorocarbon resin and at least one poly-functional unsaturated hydrocarbon derivative, wherein the mass fraction of the poly-functional unsaturated hydrocarbon derivative in the monomer vapor is 15-65 %;
(5) Stop the supply of the monomer vapor, and in the meanwhile, stop the plasma discharge, vacuum continuously so as to keep the vacuum degree of the reaction chamber in the scope of 10-200 millitorr for 1-5 min, then send in the air to one barometric pressure, stop the movement of the substrate, and take out the substrate.

Under the low vacuum plasma discharge environment, chemical bonds of the monomers with an active molecular structure are broken via the effective output of energy, and free radicals of high activity are formed, then the free radicals in the excited state and the activated groups on surfaces of mobile phones and other products initiate polymerization by means of chemical bond combination to form a nano waterproof membrane and form a multi-functional nano coating on the substrate surface.

In the Step (1), the substrate moves in the reaction chamber, and the movement form of the substrate is straight reciprocating motion or curvilinear motion relative to the reaction chamber, wherein the curvilinear motion includes circular motion, elliptic motion, planetary motion, spherical motion and curvilinear motion of other irregular routes.

The substrate in the Step (1) is a solid material, and the solid material can be electronic products, electrical components, assembled electronic semi-finished products, PCB boards, metal plates, Teflon plates or electronic parts and components, and when the substrate surface is provided with a multi-functional nano coating, any of the surfaces can be exposed to an environment of water, fungi, acid or alkaline solvents, acid or alkaline salt spray, acidic atmosphere, organic solvent immersion, cosmetics, perspiration, thermal cycling impact or alternating dampness and heat.

In the Step (1), the volume of the reaction chamber is 50-1000 L, the temperature of the reaction chamber is controlled within the range of 30-60 °C, and the incoming flow of the inert gas is 5-300 sccm.

The reaction chamber is a rotary chamber or cubic chamber.

The introduction of a monomer vapor is to atomize and volatilize the monomer through the feeding pump, and introduce the monomer to the reaction chamber by a low pressure of 10-200 millitorr, and the incoming flow of the monomer is 10-1000 µL/min;
the mono-functional unsaturated fluorocarbon resin consists of:
3-(perfluoro-5-methyl hexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluoro octyl ethyl acrylate, 1H, 1H, 2H, 2H-perfluoro octanol acrylate, 2-(perfluorobutyl) ethyl acrylate, (2H-perfluoro propyl)-2-acrylate, (perfluoro cyclohexyl) methyl acrylate, 3, 3, 3-trifluoro-1-propyne, 1-ethinyl-3, 5-difluorobenzene or 4-ethinyl trifluorotoluene;
the poly-functional unsaturated hydrocarbon derivative consists of:
   Ethoxylated trimethylolpropane triacrylate, tripropylene glycol diacrylate, poly (ethylene glycol) diacrylate, 1, 6-hexanediol diacrylate, diacrylicgylcol ester, diethylene glycol divinyl ether, or neopentyl glycol diacrylate.

In the Steps (3) and (4), the plasma discharge mode is radio frequency discharge, microwave discharge, intermediate frequency discharge, high frequency discharge or spark discharge, and the waveforms of high frequency discharge and intermediate frequency discharge are sinusoidal or bipolar pulses. The radio frequency plasmas are plasmas generated from the discharge of high frequency electromagnetic field. The microwave method is to use microwave energy to activate plasmas and has an advantage of high energy utilization efficiency; and in the meanwhile, plasmas are pure due to electrodeless discharge, at present, it is an excellent method for high quality, high speed and large area preparation.

During the preparation of coating, the kinetic characteristics of the substrate interact with the plasma discharge energy. During the preparation process, the substrate moves at the time of plasma discharging, which increase the coating deposition efficiency, and also improve the uniformity and compactness of the coating thickness.

The prepared coating is characterized by the properties of resistance to water, moisture, fungus, acid and alkaline solvents, acid and alkaline salt sprays, acidic atmosphere, organic solvent immersion, cosmetics, perspiration, thermal cycling impact (-40 °C-+75 °C) and alternating dampness and heat (humidity: 75%-95%). At the time of having the above protective properties, the influence of the coating on radio frequency communication signals within the range of 10 M-8 G is lower than 5 % When the coating thickness is 1-1000 nm.

The above technical solution of the present invention has the following advantages relative to the prior art:
1. A high-power pretreatment activation phase is brought in during the cyclic coating process in a phased manner, the introduction of this cycle is conducive to generating more active sites on the substrate surface at this stage, improving the effective coating, and resulting in a more compact coating structure and better protective effects against corrosive environment. In the coating process, the adoption of a cyclic coating process obtains a nano coating with a multiple layer composite structure, which provides multiple layers of protection for the product itself. There is a more compact coating structure microscopically, while on the macro level, it shows excellent hydrophobic property, adhesive force, acid and alkali resistance, mechanical property, and dampness and heat resistance.
2. During the coating process, cyclic pulse discharge is adopted in the coating phase, which can generate plasmas with sufficient energy to break up the incoming monomer segments to form more excited chain segments; when the segment ends in the excited state bond, via active sites having certain energy and activity in the monomer material, with active sites having corresponding energy on the substrate surface in a form of chemical bonds, more and more complicated elementary reactions will happen and a more compact cross-linked netlike structure will be formed;
3. During the pretreatment and coating phases, the substrate moves in the reaction chamber, making the coating thicknesses at different positions of the substrate tend to be consistent and solving the issue of uneven coating thickness on the substrate surface caused by different monomer densities in different areas of the reaction chamber.
4. During the preparation process, the kinetic characteristics of substrate interact with the plasma discharge energy. The substrate moves at the time of outputting plasma discharge energy, which increases the deposition efficiency and greatly improves the compactness of the obtained multi-functional nanocoating for protection. Since the deposition efficiency is improved, the applied amount of chemical monomer raw materials in the monomer vapor is only 10%-15% of the applied amount according to the prior art, thereby reducing the emission of exhaust and waste gases and being more environmental friendly. The present invention is of great significance in the improvement of actual production efficiency.
5. The introduction of poly-functional cross linked structures in monomer materials promotes, in terms of microstructure, the formation of a compact mesh structure of the coating, and improves the acid/alkali corrosion resistance of the coating in various environments while ensuring hydrophobicity .

Mono-functional monomers are selected for general plasmas polymerization so as to obtain a coating of a cross-linked structure. The cross-linked structure is formed by the cross-linking of lots of active sites which are generated from the broken chains in monomers at the time of plasma discharging. However, such cross-linked structures are relatively loose and have many linear components, thus their solution permeability resistance and dissolubility are poor. Through the introduction of other monomer components of poly-functional cross-linked structures, the present invention brings in additional cross-linking points so as to form cross-linked structures. At the time of plasma discharging, the active groups with high energy in monomer components will be broken through the effective control and output of energy and under the action of low temperature plasmas, so as to form active sites. The introduced additional active sites carry out cross-linking and polymerization with each other in the plasma environment, thereby forming compact mesh structures.

Compared with coating structures of many loose linear components, the mesh structure has better compactness and can effectively improve the corrosion resistance of a film. In a plasma environment, the surface of the coated substrate is activated to obtain numerous active sites, and such active sites will, through strong chemical bonds, be bonded with the active free radicals of a monomer material activated by plasmas, leading to elementary reactions of various forms and types such that the nano film of the substrate material has an excellent binding force and mechanical strength. Effective control and adjustment of corrosion resistance on the material surface can be realized by controlling combinations of different monomers and different process conditions, and the structure which has a special microstructure, a compact base layer and a rough surface layer can be obtained. Its comprehensive property of environmental corrosion resistance is improved by 25%-45%.

6. The polymer nano coating of a composite and gradually changed structure is obtained by introducing other monomer components with cross-linked structures, controlling the monomer ratio, providing the equipment corresponding energy outputs and effective changes of process parameters according to differences in molecular bond energies, bond lengths and vaporization temperatures of different monomers, which not only ensures the hydrophobicity of the film, but also improves the resistance of electronic products and other products against corrosive environment.

In daily life, electronic devices are liable to be damaged because of the corrosion caused by corrosive environment. Since they are used mostly in a corrosive environment, irreversible damages will occur to the electronic devices after a long period. The coating method according to the present invention makes nano technologies much more useful in improving the actual production efficiency. Thanks to the service life of the coating in a corrosive environment, the protective effects on products have been improved. It is mainly applied to the products as follows:
(1) Portable equipment keyboards: portable keyboards are small and light, and are often used on computers, mobile phones and other devices. They can facilitate users to work during trips. However, when they are contaminated by common liquids, such as water from accidently tipped cups and soaking by rain water or sweat, the inside of a keyboard can be easily short circuited and broken down. When this nano coating is applied to a keyboard, it can ensure that the keyboard surface is easy for cleaning, the keyboard remains intact when exposed to water, and the keyboard can adapt to more severe environments.
(2) LED display screens: LED display screens are used for commodity advertisement, store decoration, illumination, warning and other purposes. For some purposes, LED display screens may be exposed to rain water, heavy dust or other severe environments. For example, when it rains, for outdoor LED display screens of shopping malls, warning lights on roads and LED display control panels in workshops tend to fail due to such severe environments. Moreover, dust can easily accumulate on LED display screens and is not easy to be cleaned; however, after the nano coating is adopted, the issues can be solved effectively.
(3) Intelligent fingerprint lock: fingerprint lock is an intelligent lock. It combines computer information technologies, electronic technologies, mechanical technologies and modern hardware technologies, and is widely applied to police criminal investigation and judicial fields. However, when exposed to water, its internal circuit tends to be short circuited. It is so hard to repair that such a lock must be violently removed. After this coating is applied, this issue can be avoided.
(4) Hearing aid and Bluetooth earphone: neither a hearing aid nor a Bluetooth earphone has communication lines. After adopting this coating, users can use such devices in a water environment, such as showers and rainy days, within a certain time, and such devices will not be damaged by immersed in rain water.
(5) Some sensors: some sensors need to be used in a liquid environment, such as water pressure and oil pressure sensors, sensors used in underwater equipment, and sensors usually exposed to water in work environment. After such sensors are provided with the coating, they will not be broken down by invasion of a liquid into the internal structures of mechanical devices.
(6) The majority of 3C products: such as mobile phones, notebook computers, PSP, and so on.
(7) Other devices that should be waterproof: including devices that operate in a wet environment, or may encounter unforeseen circumstances, such as spills by common liquids, which will affect the normal operation of their internal weak current circuits.

The multi-functional nano coating prepared with this method can also be applied to the following different environments and related products:

Water resistance, moisture resistance and fungus resistance:
1. Interior decoration of houses: ceiling, wallpaper, ceiling lamp, window curtain and screening in a bathroom. 2. Articles of daily use: mosquito net, table lamp cover, chopstick holder, and automobile rearview mirror. 3. Cultural relics and works of art: copybook for calligraphy, antique, wood carving, leather, bronze ware, silk, ancient costume and ancient book. 4. Electronic components and electronic products: sensors (working in humid or dusty environments), chips of various electronic products (electronic sphygmomanometers and intelligent watches), circuit boards, mobile phones, LED display screens, and hearing aids. 5. Precision instruments and optical devices: mechanical watches and microscopes.

Resistance to acid and alkaline solvents, resistance to acid and alkaline salt sprays, and resistance to acidic atmosphere:
1. Interior trim parts of houses: wallpaper and ceramic tiles. 2. Protective appliance: Acid (alkali) proof gloves and acid (alkali) proof protective clothing. 3. Mechanical equipment and pipelines: flue gas desulfurization equipment, sealing elements (acid / alkaline lubricating oil), pipelines, valves, and lining of large diameter marine conveying pipelines. 4. Various reaction kettles and reactors. 5. Production and storage of chemicals, sewage treatment and aeration tanks. 6. Others: acid and alkali workshops, anti-alkali aerospace, energy and power, ferrous metallurgy, petro-chemical, medical treatment and other industries, storage containers, statues (to mitigate corrosion by acid rain), and sensors (in acidic / alkaline environments).

Resistance to organic solvent immersion, cosmetic resistance, and perspiration resistance:
1. Alkane, alkene, alcohol, aldehyde, amine, ester, ether, ketone, aromatic hydrocarbon, hydrogenated hydrocarbon, terpene hydrocarbon, halohydrocarbon, heterocyclic compound, nitrogen containing compound and sulfocompound solvents; 2. Cosmetic packaging containers; 3. Fingerprint locks and earphones.

Resistance to thermal cycling impact (-40 °C-+75 °C), resistance to alternating dampness and heat (humidity: 75%-95%): electrical engineering, electronic and automotive electrical appliances, such as devices in fields of aerospace, auto, home appliances and scientific research.

### DETAILED DESCRIPTION

The following figure and embodiments are provided to further illustrate the present invention, but the present invention is not limited by the embodiments.

### Embodiment 1

A method for cyclically preparing a multi-functional nanocoating for protection through high duty ratio pulse discharge, which consists of the following steps:
(1) Put a substrate into a reaction chamber of nano coating preparation equipment, close the reaction chamber and vacuum the reaction chamber continuously until the vacuum degree in the reaction chamber is 10 millitorr, then send in an inert gas (Ar), and turn on a movement mechanism so that the substrate can move in the reaction chamber;
   the substrate used in the Step (1) is a solid material, and the solid material is bulk aluminum material. When the substrate surface is provided with the acidic and alkaline environment resistant coating, any of the surfaces can be exposed to acid and alkali test environments.
   The volume of the reaction chamber in the Step (1) is 50 L, the temperature in the reaction chamber is controlled at 30°C, and the incoming flow of the inert gas is 5 sccm.
   In the Step (1), the substrate moves in the reaction chamber, and the movement form of the substrate is a circular motion relative to the reaction chamber with a speed of 4 r/min.
(2) Send a monomer vapor into the reaction chamber till the vacuum degree reaches 30 millitorr, enable the plasma discharge, and carry out chemical vapor deposition;
(3) The deposition process consists of pretreatment and coating phases. In the pretreatment phase, the plasma discharge power is 400 W, and the continuous discharge time is 60 s; subsequently in the coating phase in which the discharge plasma is pulse discharge, the power is 200 W, and the time is 600 s;
(4)Repeat the pretreatment and coating phases in the Step (3) for 11 times to prepare a multi-functional nano coating through chemical vapor deposition on the substrate surface;
   in the Steps (3) and (4), the pulse discharge frequency is 1 Hz, and the pulse duty ratio is 1: 1;
   in the Step (2):
      the introduction of a monomer vapor is to atomize and volatilize the monomer through the feeding pump, and to introduce the monomer to the reaction chamber by a low pressure of 10millitorr, and the incoming flow of the monomer is 1000 µL/min;
      the components of the monomer vapor are:
         a mixture of two mono-functional unsaturated fluorocarbon resins and two poly-functional unsaturated hydrocarbon derivatives, wherein the mass fraction of the poly-functional unsaturated hydrocarbon derivatives in the monomer vapor is 15%;
         the mono-functional unsaturated fluorocarbon resins are: 2-perfluoro octyl ethyl acrylate and 2-(perfluorohexyl) ethyl methacrylate;
         the poly-functional unsaturated hydrocarbon derivatives are: poly (ethylene glycol) diacrylate and 1, 6-hexanediol diacrylate;
         in the Steps (3) and (4), the plasma discharge mode is continuous radio frequency discharge.
(5) When the coating is completed, stop the introduction of the raw material monomer vapor, and in the meanwhile, stop the plasma discharge; **vacuum** continuously so as to keep the vacuum degree of reaction chamber at 10 millitorr for Imin, then send in the air to one barometric pressure, and take out the substrate.

The performance test results of the aluminum plate deposited with the above coating are shown as follows:
(1) Hydrophobicity/lipophobicity effect

| hydrophobicity/lipophobicity | | | |
|---|---|---|---|
| Thickness | Water contact angle | Oil contact angle | Adhesion |
| 250nm | 127° | 98° | Low adhesion, water droplets easily slipped |

(2) Results of the acidity / alkalinity test: (pass represents that there is no corrosion after the test proceeds for a period of time)

| Acid / alkali reagents | Time | | | |
|---|---|---|---|---|
| | 64h | 112h | 160h | 208h |
| Acidic salt spray | pass | pass | pass | pass |
| Neutral salt spray | pass | pass | pass | pass |
| Alkaline salt spray | pass | pass | pass | pass |
| 5% Acetic acid solution | pass | pass | pass | pass |
| 5% NaOH solution | pass | pass | pass | pass |

(3) Results of the organic solvent resistance test:(pass represents that after immersion for a period of time, the change of contact angle is less than 5°)

| Chemical reagents | Time | | | |
|---|---|---|---|---|
| | 64h | 112h | 160h | 208h |
| Acetone | pass | pass | pass | pass |
| Cyclohexane | pass | pass | pass | pass |
| Petroleum ether | pass | pass | pass | pass |
| Xylene | pass | pass | pass | pass |
| 1-Propanol | pass | pass | pass | pass |

### Embodiment 2

A method for cyclically preparing a multi-functional nanocoating for protection through high duty ratio pulse discharge, which consists of the following steps:
(1) Put a substrate into a reaction chamber of nano coating preparation equipment, close the reaction chamber and vacuum the reaction chamber continuously until the vacuum degree in the reaction chamber is 60 millitorr, then send in an inert gas (He), and turn on a movement mechanism so that the substrate can move;
   the substrate used in the Step (1) is a solid material, and the solid material is bulk aluminum material. When the substrate surface is provided with a coating resistant to organic solvent immersion and cosmetics, any of the surfaces can be exposed to the organic solvent test environment.
   The volume of the reaction chamber in the Step (1) is 250 L, the temperature in the reaction chamber is controlled at 40°C, and the incoming flow of the inert gas is 15 sccm.
   In the Step (1), the substrate carries out planetary motion, the revolution speed is 3 r/min, and the auto rotation speed is 5 r/min.
(2) Send a monomer vapor into the reaction chamber till the vacuum degree reaches 90 millitorr, enable the plasma discharge, and carry out chemical vapor deposition;
(3) The deposition process consists of pretreatment and coating phases. In the pretreatment phase, the plasma discharge power is 120 W, and the continuous discharge time is 450 s; subsequently in the coating phase in which the discharge plasma is pulse discharge, the power is50W, and the time is 3600 s;
(4)Repeat the pretreatment and coating phases in the Step (3) for 1 time to prepare a multi-functional nano coating through chemical vapor deposition on the substrate surface;
   in the Steps (3) and (4), the pulse discharge frequency is 60 Hz, and the pulse duty ratio is 1:90;
   in the Step (2):
   the introduction of a monomer vapor is to atomize and volatilize the monomer through the feeding pump, and to introduce the monomer to the reaction chamber by a low pressure of 60 millitorr, and the incoming flow of the monomer is 500 µL/min;
   the components of the monomer vapor are:
      a mixture of three mono-functional unsaturated fluorocarbon resins and two poly-functional unsaturated hydrocarbon derivatives, wherein the mass fraction of the poly-functional unsaturated hydrocarbon derivatives in the monomer vapor is 23 %;
      the mono-functional unsaturated fluorocarbon resins are: (2H-perfluoro propyl)-2-acrylate,2-(perfluorodecyl) ethyl methacrylate, and (perfluoro cyclohexyl) methyl acrylate;
      the poly-functional unsaturated hydrocarbon derivatives are: diethylene glycol divinyl ether and neopentyl glycol diacrylate;
      in the Steps (3) and (4), the plasma discharge mode is intermediate frequency continuous discharge, and the waveform of the intermediate frequency discharge is sinusoidal.
(5) When the coating is completed, stop the introduction of the raw material monomer vapor, and in the meanwhile, stop the plasma discharge; vacuum continuously so as to keep the vacuum degree of reaction chamber at 80 millitorr for 2 min, then send in the air to one barometric pressure, and take out the substrate.

The performance test results of the aluminum material deposited with the above coating are shown as follows:
(1) Hydrophobicity/lipophobicity effect

| hydrophobicity/lipophobicity | | | |
|---|---|---|---|
| Thickness | Water contact angle | Oil contact angle | Adhesion |
| 250nm | 128° | 97° | Low adhesion, water droplets easily slipped |

(2) Results of the acidity / alkalinity test: (pass represents that there is no corrosion after the test proceeds for a period of time)

| Acid / alkali reagents | Time | | | |
|---|---|---|---|---|
| | 64h | 112h | 160h | 208h |
| Acidic salt spray | pass | pass | pass | pass |
| Neutral salt spray | pass | pass | pass | pass |
| Alkaline salt spray | pass | pass | pass | pass |
| 5% Acetic acid solution | pass | pass | pass | pass |
| 5% NaOH solution | pass | pass | pass | pass |

(3) Results of the organic solvent resistance test:(pass represents that after immersion for a period of time, the change of contact angle is less than 5°)

| Chemical reagents | Time | | | |
|---|---|---|---|---|
| | 64h | 112h | 160h | 208h |
| Acetone | pass | pass | pass | pass |
| Cyclohexane | pass | pass | pass | pass |
| Petroleum ether | pass | pass | pass | pass |
| Xylene | pass | pass | pass | pass |
| 1-Propanol | pass | pass | pass | pass |

### Embodiment 3

A method for cyclically preparing a multi-functional nanocoating for protection through high duty ratio pulse discharge, which consists of the following steps:
(1) Put a substrate into a reaction chamber of nano coating preparation equipment, close the reaction chamber and vacuum the reaction chamber continuously until the vacuum degree in the reaction chamber is 130 millitorr, then send in an inert gas (Ar), and turn on a movement mechanism so that the substrate can move;
   the substrate used in the Step (1) is a solid material, and the solid material is bulk aluminum material. When the substrate surface is provided with a coating resistant to thermal cycling impact, any of the surfaces can be exposed to the thermal cycling test environment.
   The volume of the reaction chamber in the Step (1) is 480 L, the temperature in the reaction chamber is controlled at 50°C, and the incoming flow of the inert gas is 50 sccm.
   In the Step (1), the movement of the substrate is circular, and the speed is 2 r/min.
(2) Send a monomer vapor into the reaction chamber till the vacuum degree reaches 150 millitorr, enable the plasma discharge, and carry out chemical vapor deposition;
(3) The deposition process consists of pretreatment and coating phases. In the pretreatment phase, the plasma discharge power is 200 W, and the continuous discharge time is 150 s; subsequently in the coating phase in which the discharge plasma is pulse discharge, the power is 80 W, and the time is 1000 s;
(4)Repeat the pretreatment and coating phases in the Step (3) for 5 times to prepare a multi-functional nano coating through chemical vapor deposition on the substrate surface;
   in the Steps (3) and (4), the pulse discharge frequency is 200 Hz, and the pulse duty ratio is 1:180;
   in the Step (2):
   the introduction of a monomer vapor is to atomize and volatilizethe monomer through the feeding pump, and to introduce the monomer to the reaction chamber by a low pressure of 10 millitorr, and the incoming flow of the monomer is 550 µL/min;
   the components of the monomer vapor are:
      a mixture of two mono-functional unsaturated fluorocarbon resins and two poly-functional unsaturated hydrocarbon derivatives, wherein the mass fraction of the poly-functional unsaturated hydrocarbon derivatives in the monomer vapor is 35 %;
      the mono-functional unsaturated fluorocarbon resins are: (perfluoro cyclohexyl) methyl acrylate and 2-(perfluorohexyl) ethyl methacrylate;
      the poly-functional unsaturated hydrocarbon derivatives are: ethoxylated trimethylolpropane triacrylate and 1, 6-hexanediol diacrylate;
      in the Steps (3) and (4), the plasma discharge mode is high frequency continuous discharge, and the waveform of the high frequency discharge is sinusoidal.
(5) When the coating is completed, stop the introduction of the raw material monomer vapor, and in the meanwhile, stop the plasma discharge; vacuum continuously so as to keep the vacuum degree of reaction chamber at 130 millitorr for 3 min, then send in the air to one barometric pressure, and take out the substrate.

The thermal cycling impact test results of the coated aluminum material are shown as follows:

| Substrate to be tested | Test condition | Number of cycles | Test time | Result detection |
|---|---|---|---|---|
| Aluminum substrate | -40°C-+75°C | 25 | 6h | No effect on appearance Good performance |
| PCB board | -40°C-+75°C | 25 | 6h | No effect on appearance Good performance |

### Embodiment 4

A method for cyclically preparing a multi-functional nanocoating for protection through high duty ratio pulse discharge, which consists of the following steps:
(1) Put a substrate into a reaction chamber of nano coating preparation equipment, close the reaction chamber and vacuum the reaction chamber continuously until the vacuum degree in the reaction chamber is 160 millitorr, then send in an inert gas (He), and turn on a movement mechanism so that the substrate can move;
   the substrate used in the Step (1) is a solid material, and the solid material is bulk aluminum alloy material. When the substrate surface is provided with a coating resistant to alternating dampness and heat, any of the surfaces can be exposed to the dampness and heat test environment.
   The volume of the reaction chamber in the Step (1) is 680 L, the temperature in the reaction chamber is controlled at 50°C, and the incoming flow of the inert gas is 160 sccm.
   In the Step (1), the substrate performs a straight reciprocating motion, and the speed is 40 mm/min.
(2) Send a monomer vapor into the reaction chamber till the vacuum degree reaches 190 millitorr, enable the plasma discharge, and carry out chemical vapor deposition;
(3) The deposition process consists of pretreatment and coating phases. In the pretreatment phase, the plasma discharge power is 300 W, and the continuous discharge time is 250 s; subsequently in the coating phase in which the discharge plasma is pulse discharge, the power is 120 W, and the time is 2000 s;
(4) Repeat the pretreatment and coating phases in the Step (3) for 3 times to prepare a multi-functional nano coating through chemical vapor deposition on the substrate surface;
   in the Steps (3) and (4), the pulse discharge frequency is 400 Hz, and the pulse duty ratio is 1:400;
   in the Step (2):
   the introduction of a monomer vapor is to atomize and volatilize the monomer through the feeding pump, and to introduce the monomer to the reaction chamber by a low pressure of 160 millitorr, and the incoming flow of the monomer is 220 µL/min;
   the components of the monomer vapor are:
      a mixture of two mono-functional unsaturated fluorocarbon resins and two poly-functional unsaturated hydrocarbon derivatives, wherein the mass fraction of the poly-functional unsaturated hydrocarbon derivatives in the monomer vapor is 39 %;
      the mono-functional unsaturated fluorocarbon resins are:3-(perfluoro-5-methyl hexyl)-2-hydroxypropyl methacrylate and 1H, 1H, 2H, 2H-perfluoro octanol acrylate;
      the poly-functional unsaturated hydrocarbon derivatives are: diacrylicgylcol ester and 1, 6-hexanediol diacrylate;
      in the Steps (3) and (4), the plasma discharge mode is microwave continuous discharge.
(5) When the coating is completed, stop the introduction of the raw material monomer vapor, and in the meanwhile, stop the plasma discharge; vacuumize continuously so as to keep the vacuum degree of reaction chamber at 160 millitorr for 4 min, then send in the air to one barometric pressure, and take out the substrate.

The alternating dampness and heat test results of the coated bulk aluminum alloy material are shown as follows:

| Substrate to be tested | Test conditions and results | | | | | | |
|---|---|---|---|---|---|---|---|
| Aluminum alloy material | Temperature | | 85°C | | | | |
| | Humidity | | 75% | 80% | 85% | 90% | 95% |
| | Time | 24h | Pass | Pass | Pass | Pass | Pass |
| | Time | 36h | Pass | Pass | Pass | Pass | Pass |
| | Time | 48h | Pass | Pass | Pass | Pass | Pass |
| | Time | 60h | Pass | Pass | Pass | Pass | Pass |

### Embodiment 5

A method for cyclically preparing a multi-functional nanocoating for protection through high duty ratio pulse discharge, which consists of the following steps:
(1) Put a substrate into a reaction chamber of nano coating preparation equipment, close the reaction chamber and vacuum the reaction chamber continuously until the vacuum degree in the reaction chamber is 200 millitorr, then send in an inert gas (Ar), and turn on a movement mechanism so that the substrate can move;
   the substrate used in the Step (1) is a solid material, and the solid material is a block of a Teflon plate and an electric appliance part. When the surface of the Teflon plate is provided with the fungus resistant nano coating, any of the surfaces can be exposed to a fungus test environment under GJB150.10A-2009, and when the surface of the electric appliance part is provided with the coating which is waterproof and resistant to electric breakdown, any of the surfaces can be exposed to the environment described in the International Industrial Waterproof Rating IPX7.
   The volume of the reaction chamber in the Step (1) is 1000 L, the temperature in the reaction chamber is controlled at 60°C, and the incoming flow of the inert gas is 300sccm.
   In the Step (1), the substrate carries out planetary motion, the revolution speed is 3 r/min, and the auto rotation speed is 4.5 r/min.
(2) Send a monomer vapor into the reaction chamber till the vacuum degree reaches 300 millitorr, enable the plasma discharge, and carry out chemical vapor deposition;
(3) The deposition process consists of pretreatment and coating phases. In the pretreatment phase, the plasma discharge power is 150 W, and the continuous discharge time is 400 s; subsequently in the coating phase in which the discharge plasma is pulse discharge, the power is 160W, and the time is 3000 s;
(4) Repeat the pretreatment and coating phases in the Step (3) for 2 times to prepare a multi-functional nano coating through chemical vapor deposition on the substrate surface;
   in the Steps (3) and (4), the pulse discharge frequency is 700 Hz, and the pulse duty ratio is 1:800;
   in the Step (2):
   the introduction of a monomer vapor is to atomize and volatilize the monomer through the feeding pump, and to introduce the monomer to the reaction chamber by a low pressure of 200 millitorr, and the incoming flow of the monomer is 10 µL/min;
   the components of the monomer vapor are:
      a mixture of three mono-functional unsaturated fluorocarbon resins and two poly-functional unsaturated hydrocarbon derivatives, wherein the mass fraction of the poly-functional unsaturated hydrocarbon derivatives in the monomer vapor is 65 %;
      the mono-functional unsaturated fluorocarbon resins are: 1H, 1H, 2H, 2H- perfluoro octanol acrylate, 3, 3, 3-trifluoro-1-propyne, and 2-(perfluorohexyl) ethyl methacrylate;
      the poly-functional unsaturated hydrocarbon derivatives are: tripropylene glycol diacrylate and diacrylicgylcol ester;
      in the Steps (3) and (4), the plasma discharge mode is spark discharge.
(5) When the coating is completed, stop the introduction of the raw material monomer vapor, and in the meanwhile, stop the plasma discharge; vacuum continuously so as to keep the vacuum degree of reaction chamber at 200 millitorr for 5 min, then send in the air to one barometric pressure, and take out the substrate.

The results of GJB150.10A-2009 fungus test on the above coated Teflon plate are as follows:

| Teflon plate - Performance test | |
|---|---|
| Water contact angle | 138° |
| Oil contact angle | 98° |
| Fungus resistance grade | Grade 2 |
| Degree of surface fungus spots | 4% |

The underwater immersion test results of the above coated electric appliance part at different voltages are as follows:

| Underwater energization resistance | | | |
|---|---|---|---|
| | Time for the current to reach 1 mA at certain voltage | | |
| | 3.8V | 5V | 12.5V |
| Embodiment 5 | >64h | >48h | >36h |

IPX 7 Waterproof Rating test (water immersion test for 30min at a depth of 1m underwater)results:

| IPX7 Waterproof Rating test | |
|---|---|
| Embodiment 5 | The electric appliance part works normally |

### Embodiment 6

This embodiment has the same basic process steps as those of Embodiment 5, and the different process parameters are as follows:
1. In the Step (1), vacuum the reaction chamber such that the vacuum degree in the reaction chamber is 120 millitorr, and then send in an inert gas (Ar);
   the substrate used in the Step (1) is a solid material, and the solid material is a block of a Teflon plate and an electric appliance part. When the surface of the Teflon plate is provided with the fungus resistant nano coating, any of the surfaces can be exposed to a fungus test environment under GJB150.10A-2009, and when the surface of the electric appliance part is provided with the coating which is waterproof and resistant to electric breakdown, any of the surfaces can be exposed to the environment described in the International Industrial Waterproof Rating IPX7.

The volume of the reaction chamber in the Step (1) is 400 L, the temperature in the reaction chamber is controlled at 40°C, and the incoming flow of the inert gas is 150 sccm.
(2) Send a monomer vapor into the reaction chamber till the vacuum degree reaches 160 millitorr, enable the plasma discharge, and carry out chemical vapor deposition;
(3) The deposition process consists of pretreatment and coating phases. In the pretreatment phase, the plasma discharge power is 180 W, and the continuous discharge time is 200 s; subsequently in the coating phase in which the discharge plasma is pulse discharge, the power is 180W, and the time is 1500 s;
(4)Repeat the pretreatment and coating phases in the Step (3) for 3 times to prepare a multi-functional nano coating through chemical vapor deposition on the substrate surface;
   in the Steps (3) and (4), the pulse discharge frequency is 1000 Hz, and the pulse duty ratio is 1:1000;
   in the Step (2):
   the introduction of a monomer vapor is to atomize and volatilize the monomer through the feeding pump, and to introduce the monomer to the reaction chamber by a low pressure of160millitorr, and the incoming flow of the monomer is 200 µL/min;
   the components of the monomer vapor are:
      a mixture of four mono-functional unsaturated fluorocarbon resins and two poly-functional unsaturated hydrocarbon derivatives, wherein the mass fraction of the poly-functional unsaturated hydrocarbon derivatives in the monomer vapor is 48 %;
      the mono-functional unsaturated fluorocarbon resins are: 2-(perfluorodecyl) ethyl methacrylate, 1H, 1H, 2H, 2H- perfluoro octanol acrylate, 3, 3, 3-trifluoro-1-propyne, and 2-(perfluorohexyl) ethyl methacrylate;
      the poly-functional unsaturated hydrocarbon derivatives are: tripropylene glycol diacrylate and diethylene glycol divinyl ether;

2. In the Step (5), keep the vacuum degree of the reaction chamber at 160 millitorr for 5 min, and then send in the air to one barometric pressure.

The results of GJB150. 10A-2009 fungus test on the above coated Teflon plate are as follows:

| Teflon - Performance test | |
|---|---|
| Water contact angle | 139° |
| Oil contact angle | 97° |
| Fungus resistance grade | Grade 2 |
| Degree of surface fungus spots | 4% |

The underwater immersion test results of the above coated electric appliance part at different voltages are as follows:

| Underwater energization resistance | | | |
|---|---|---|---|
| | Time for the current to reach 1 mA at certain voltage | | |
| | 3.8V | 5V | 12.5V |
| Embodiment 5 | >60h | >45h | >35h |

IPX 7 Waterproof Rating test (water immersion test for 30min at a depth of 1m underwater)results:

| IPX7 Waterproof Rating test | |
|---|---|
| Embodiment 5 | The electric appliance part works normally |

## Claims

1. A method for cyclically preparing a multi-functional nanocoating having a thickness of 1-1000 nm for protection through high duty ratio pulse discharge, wherein the method consists of the following steps:
(1) putting a substrate into a reaction chamber of nano coating preparation equipment, vacuumizing the reaction chamber continuously until the vacuum degree in the reaction chamber is in a range of 10-200 millitorr, then sending in an inert gas, and turning on a movement mechanism to allow the substrate to move in the reaction chamber, wherein the inert gas is He or Ar, the volume of the reaction chamber is 50-1000 L, the temperature of the reaction chamber is controlled within a range of 30-60°C, and the incoming flow of the inert gas is 5-300 sccm, and the reaction chamber is a rotary chamber or cubic chamber;
(2) sending a monomer vapor into the reaction chamber till the vacuum degree reaches 30-300 millitorr, enabling plasma discharge, and carrying out chemical vapor deposition consisting of pretreatment and coating phases;
(3) performing the pretreatment and coating phases to activate the surface of the substrate; wherein in the pretreatment phase, plasma discharge power is 120-400 W, and continuous discharge time is 60-450 s; subsequently in the coating phase, the plasma discharge is pulse discharge, power is 50-200 W, and time is 600 s-3600 s;
(4) repeating the pretreatment and coating phases in the Step (3) at least once to activate the surface of a coating layer to prepare a multi-functional nano coating through the chemical vapor deposition on a substrate surface; wherein
in the Steps (3) and (4), a pulse discharge frequency is 1-1000 Hz, and a pulse duty ratio is 1:1-1:1000;
components of the monomer vapor are:
a mixture of at least one mono-functional unsaturated fluorocarbon resin and at least one poly-functional unsaturated hydrocarbon derivative, wherein a mass fraction of the poly-functional unsaturated hydrocarbon derivatives in the monomer vapor is 15-65%; wherein the mono-functional unsaturated fluorocarbon resin consists of: 3-(perfluoro-5-methyl hexyl)-2-hydroxypropyl methacrylate, 2-(perfluorodecyl) ethyl methacrylate, 2-(perfluorohexyl) ethyl methacrylate, 2-(perfluorododecyl) ethyl acrylate, 2-perfluoro octyl ethyl acrylate, 1H, 1H, 2H, 2H- perfluoro octanol acrylate, 2-(perfluorobutyl) ethyl acrylate, (2H-perfluoro propyl)-2-acrylate, (perfluoro cyclohexyl) methyl acrylate, 3, 3, 3-trifluoro-1-propyne, 1-ethinyl-3, 5-difluorobenzene or 4-ethinyl trifluorotoluene; and the poly-functional unsaturated hydrocarbon derivative consists of: ethoxylated trimethylolpropane triacrylate, tripropylene glycol diacrylate, poly (ethylene glycol) diacrylate, 1, 6-hexanediol diacrylate, diacrylicgylcol ester, diethylene glycol divinyl ether, or neopentyl glycol diacrylate;
(5) stopping supplying the monomer vapor, and in the meanwhile, stopping the plasma discharge, vacuumizing continuously, sending in the air to one barometric pressure after keeping the vacuum degree of the reaction chamber in a range of 10-200 millitorr for 1-5 min, stopping a movement of the substrate, and taking out the substrate, wherein
in the Steps (3) and (4), in the pretreatment phase, the plasma discharge mode is high power continuous discharge; in the coating phase, the discharge mode of plasma is high duty ratio pulse discharge.

2. The method for cyclically preparing the multi-functional nanocoating for protection through the high duty ratio pulse discharge according to claim 1, **characterized in that** in the Step (1), the substrate moves in the reaction chamber, and a movement form of the substrate is a straight reciprocating motion or a curvilinear motion relative to the reaction chamber, wherein the curvilinear motion comprises circular motion, elliptic motion, planetary motion, spherical motion and curvilinear motion of other irregular routes.

3. The method for cyclically preparing the multi-functional nanocoating for protection through the high duty ratio pulse discharge according to claim 1, **characterized in that** the substrate in Step (1) is a solid material, and the solid material is electronic products, electrical components, assembled electronic semi-finished products, PCB boards, metal plates, Teflon plates or electronic parts and components, and when the substrate surface is provided with the multi-functional nanocoating for protection, any of the surfaces is used in exposure to an environment of water, fungi, acid or alkaline solvents, acid or alkaline salt spray, acidic atmosphere, organic solvent immersion, cosmetics, perspiration, thermal cycling impact or alternating dampness and heat.

4. The method for cyclically preparing the multi-functional nanocoating for protection through the high duty ratio pulse discharge according to claim 1, **characterized in that** the Step (2) of sending the monomer vapor includes atomizing and volatilizing a monomer through a feeding pump, and introducing the monomer to the reaction chamber by a low pressure of 10-200 millitorr, wherein an incoming flow of the monomer is 10-1000 µL/min.

5. The method for cyclically preparing the multi-functional nanocoating for protection through the high duty ratio pulse discharge according to claim 1, **characterized in that** in the Steps (3) and (4), a mode of the plasma discharge is radio frequency discharge, microwave discharge, intermediate frequency discharge, high frequency discharge or spark discharge, and waveforms of high frequency discharge and intermediate frequency discharge are sinusoidal or bipolar pulses.

## Patentansprüche

1. Verfahren zur zyklischen Herstellung einer multifunktionellen Nanobeschichtung mit einer Dicke von 1-1000 nm zum Schutz durch Impulsentladung mit hohem Tastverhältnis, wobei das Verfahren aus den folgenden Schritten besteht:
(1) Einbringen eines Substrats in eine Reaktionskammer einer Nanobeschichtungsherstellungsanlage, kontinuierliches Vakuumieren der Reaktionskammer, bis der Vakuumgrad in der Reaktionskammer in einem Bereich von 10-200 Millitorr liegt, dann Einleiten eines Inertgases und Einschalten eines Bewegungsmechanismus, um es dem Substrat zu ermöglichen, sich in der Reaktionskammer zu bewegen, wobei das Inertgas He oder Ar ist, das Volumen der Reaktionskammer 50-1000 l beträgt, die Temperatur der Reaktionskammer in einem Bereich von 30-60 °C gesteuert wird und der einströmende Strom des Inertgases 5-300 sccm beträgt und die Reaktionskammer eine rotationssymmetrische Kammer oder eine kubische Kammer ist;
(2) Einleiten eines Monomerdampfes in die Reaktionskammer, bis der Vakuumgrad 30-300 Millitorr erreicht, Ermöglichen einer Plasmaentladung und Durchführen einer chemischen Dampfabscheidung, die aus einer Vorbehandlungsphase und einer Beschichtungsphase besteht;
(3) Durchführen der Vorbehandlungsphase und der Beschichtungsphase, um die Oberfläche des Substrats zu aktivieren; wobei in der Vorbehandlungsphase die Plasmaentladungsleistung 120-400 W beträgt und die kontinuierliche Entladungsdauer 60-450 s beträgt; anschließend in der Beschichtungsphase die Plasmaentladung eine Impulsentladung ist, die Leistung 50-200 W beträgt und die Dauer 600 s-3600 s beträgt;
(4) mindestens einmaliges Wiederholen der Vorbehandlungsphase und der Beschichtungsphase in Schritt (3), um die Oberfläche einer Beschichtungsschicht zu aktivieren, um durch die chemische Dampfabscheidung auf einer Substratoberfläche eine multifunktionelle Nanobeschichtung herzustellen; wobei
in den Schritten (3) und (4) eine Impulsentladungsfrequenz 1-1000 Hz beträgt und ein Tastverhältnis 1:1-1:1000 beträgt;
Komponenten des Monomerdampfes sind:
eine Mischung aus mindestens einem monofunktionellen ungesättigten Fluorkohlenstoffharz und mindestens einem polyfunktionellen ungesättigten Kohlenwasserstoffderivat, wobei ein Massenanteil der polyfunktionellen ungesättigten Kohlenwasserstoffderivate in dem Monomerdampf 15-65 % beträgt; wobei das monofunktionelle ungesättigte Fluorkohlenstoffharz besteht aus: 3-(Perfluor-5-methylhexyl)-2-hydroxypropylmethacrylat, 2-(Perfluordecyl) ethylmethacrylat, 2-(Perfluorhexyl) ethylmethacrylat, 2-(Perfluordodecyl) ethylacrylat, 2-Perfluoroctylethylacrylat, 1H, 1H, 2H, 2H-Perfluoroctanolacrylat, 2-(Perfluorbutyl) ethylacrylat, (2H-Perfluorpropyl)-2-acrylat, (Perfluorcyclohexyl) methylacrylat, 3,3,3-Trifluor-1-propin, 1-Ethinyl-3, 5-difluorbenzol oder 4-Ethinyltrifluortoluol; und das polyfunktionelle ungesättigte Kohlenwasserstoffderivat besteht aus: ethoxyliertem Trimethylolpropantriacrylat, Tripropylenglykoldiacrylat, Poly(ethylenglykol) diacrylat, 1, 6-Hexandioldiacrylat, Diacrylgylcolester, Diethylenglykoldivinylether oder Neopentylglykoldiacrylat;
(5) Anhalten der Zufuhr des Monomerdampfes und unterdessen Anhalten der Plasmaentladung, kontinuierliches Vakuumieren, Einleiten von Luft auf einen barometrischen Druck, nachdem der Vakuumgrad der Reaktionskammer für 1-5 min in einem Bereich von 10-200 Millitorr gehalten wurde, Anhalten einer Bewegung des Substrats und Herausnehmen des Substrats, wobei
in den Schritten (3) und (4) in der Vorbehandlungsphase der Plasmaentladungsmodus eine kontinuierliche Entladung mit hoher Leistung ist; in der Beschichtungsphase der Entladungsmodus des Plasmas eine Impulsentladung mit hohem Tastverhältnis ist.

2. Verfahren zur zyklischen Herstellung der multifunktionellen Nanobeschichtung zum Schutz durch Impulsentladung mit hohem Tastverhältnis nach Anspruch 1, **dadurch gekennzeichnet, dass** sich in Schritt (1) das Substrat in der Reaktionskammer bewegt und eine Bewegungsform des Substrats eine geradlinige Hin- und Herbewegung oder eine krummlinige Bewegung relativ zur Reaktionskammer ist, wobei die krummlinige Bewegung eine Kreisbewegung, eine elliptische Bewegung, eine Planetenbewegung, eine sphärische Bewegung und eine krummlinige Bewegung entlang anderer unregelmäßiger Wege umfasst.

3. Verfahren zur zyklischen Herstellung der multifunktionellen Nanobeschichtung zum Schutz durch die Impulsentladung mit hohem Tastverhältnis nach Anspruch 1, **dadurch gekennzeichnet, dass** das Substrat in Schritt (1) ein festes Material ist und es sich bei de festes Material um elektronische Produkte, elektrische Komponenten, bestückte elektronische Halbfabrikate, Leiterplatten, Metallplatten, Teflonplatten oder elektronische Teile handelt und, wenn die Substratoberfläche mit der multifunktionellen Nanobeschichtung zum Schutz versehen ist, eine beliebige der Oberflächen in Verwendung gegenüber einer Umgebung aus Wasser, Pilzen, sauren oder alkalischen Lösungsmitteln, einem sauren oder einem alkalischen Salzsprühnebel, einer sauren Atmosphäre, einem Eintauchen in organische Lösungsmittel, Kosmetika, Schweiß, einer thermischen Zyklusbelastung oder wechselnder Feuchtigkeit und Wärme exponiert ist.

4. Verfahren zur zyklischen Herstellung der multifunktionellen Nanobeschichtung zum Schutz durch die Impulsentladung mit hohem Tastverhältnis nach Anspruch 1, **dadurch gekennzeichnet, dass** der Schritt (2) des Einleitens des Monomerdampfes das Zerstäuben und Verflüchtigen eines Monomers durch eine Beschickungspumpe und das Einleiten des Monomers in die Reaktionskammer durch einen niedrigen Druck von 10-200 Millitorr umfasst, wobei ein eingehender Strom des Monomers 10-1000 µl/min beträgt.

5. Verfahren zur zyklischen Herstellung der multifunktionellen Nanobeschichtung zum Schutz durch die Impulsentladung mit hohem Tastverhältnis nach Anspruch 1, **dadurch gekennzeichnet, dass** in den Schritten (3) und (4) ein Modus der Plasmaentladung eine Hochfrequenzentladung, eine Mikrowellenentladung, eine Zwischenfrequenzentladung, eine Hochfrequenzentladung oder eine Funkenentladung ist und Wellenformen der Hochfrequenzentladung und der Zwischenfrequenzentladung sinusförmige oder bipolare Impulse sind.

## Revendications

1. Procédé de préparation cyclique d'un nano-revêtement multifonctionnel présentant une épaisseur de 1 à 1 000 nm pour la protection au moyen d'une décharge d'impulsion à rapport cyclique élevé, dans lequel le procédé comprend les étapes suivantes
(1) placer un substrat dans une chambre de réaction d'un équipement de préparation de nano-revêtements, mettre la chambre de réaction sous vide en continu jusqu'à ce que le niveau de vide dans la chambre de réaction soit dans une plage de 10 à 200 millitorrs, puis envoyer un gaz inerte, et démarrer un mécanisme de déplacement pour permettre au substrat de se déplacer dans la chambre de réaction, le gaz inerte étant du He ou du Ar, le volume de la chambre de réaction étant de 50 à 1 000 L, la température de la chambre de réaction étant régulée dans une plage de 30 à 60 °C, et un débit entrant du gaz inerte étant de 5 à 300 sccm, et la chambre de réaction est une chambre rotative ou une chambre cubique ;
(2) envoyer une vapeur de monomère dans la chambre de réaction jusqu'à ce que le niveau de vide atteigne 30 à 300 millitorrs, permettant une décharge de plasma, et réaliser un dépôt chimique en phase vapeur consistant en des phases de prétraitement et de revêtement ;
(3) effectuer les phases de prétraitement et de revêtement pour activer la surface du substrat ; lors de la phase de prétraitement, la puissance de décharge plasma étant de 120 à 400 W, et le temps de décharge continue étant de 60 à 450 s ; ensuite, lors de la phase de revêtement, la décharge de plasma est une décharge d'impulsion, la puissance est de 50 à 200 W et la durée est de 600 s à 3 600 s ;
(4) répéter les phases de prétraitement et de revêtement à l'étape (3) au moins une fois pour activer la surface d'une couche de revêtement afin de préparer un nano-revêtement multifonctionnel par dépôt chimique en phase vapeur sur une surface de substrat ;
lors des étapes (3) et (4), une fréquence de décharge d'impulsion étant de 1 à 1 000 Hz, et un rapport cyclique d'impulsion étant de 1: 1 à 1: 1 000 ;
les composants de la vapeur de monomère étant :
un mélange d'au moins une résine fluorocarbonée insaturée monofonctionnelle et d'au moins un dérivé d'hydrocarbure insaturé polyfonctionnel, la fraction massique des dérivés d'hydrocarbures insaturés polyfonctionnels dans la vapeur de monomère étant de 15 à 65 % ; la résine fluorocarbonée insaturée monofonctionnelle consistant de : méthacrylate de 3-(perfluoro-5-méthyl hexyl)-2-hydroxypropyle, méthacrylate de 2-(perfluorodécyl) éthyle, méthacrylate de 2-(perfluorohexyl) éthyle, acrylate de 2-(perfluorododécyl) éthyle, acrylate de 2-perfluoro octyl éthyle, acrylate de 1H,1H,2H, 2H-perfluoro octanol, acrylate de 2-(perfluorobutyl) éthyle, (2H-perfluoropropyl)-2-acrylate, acrylate de (perfluoro cyclohexyl) méthyle, 3,3,3-trifluoro-1-propyne, 1-éthinyle -3, 5-difluorobenzène ou 4-éthinyl trifluorotoluène ; et le dérivé d'hydrocarbure insaturé polyfonctionnel consistant de : triacrylate de triméthylolpropane éthoxylé, diacrylate de tripropylène glycol, diacrylate de poly(éthylène glycol), diacrylate de 1,6-hexanediol, ester de diacryliqueglycol, éther divinylique de diéthylène glycol ou diacrylate de néopentyl glycol ;
(5) arrêter l'alimentation en vapeur de monomère et, entre-temps, arrêter la décharge de plasma, mettre sous vide en continu, envoyer de l'air à une pression barométrique après avoir maintenu le niveau de vide de la chambre de réaction dans une plage de 10 à 200 millitorrs pendant 1 à 5 minutes, arrêter un mouvement du substrat et retirer le substrat,
lors des étapes (3) et (4), pendant la phase de prétraitement, le mode de décharge de plasma étant une décharge continue à puissance élevée ; pendant la phase de revêtement, le mode de décharge de plasma étant une décharge à impulsion à rapport cyclique élevé.

2. Procédé de préparation cyclique d'un nano-revêtement multifonctionnel pour la protection au moyen de la décharge d'impulsion à rapport cyclique élevé selon la revendication 1, **caractérisé en ce que** lors de l'étape (1), le substrat se déplace dans la chambre de réaction, et une forme de mouvement du substrat est un mouvement alternatif rectiligne ou un mouvement curviligne par rapport à la chambre de réaction, le mouvement curviligne comprenant un mouvement circulaire, un mouvement elliptique, un mouvement planétaire, un mouvement sphérique et un mouvement curviligne d'autres itinéraires irréguliers.

3. Procédé de préparation cyclique d'un nano-revêtement multifonctionnel pour la protection au moyen de la décharge d'impulsion à rapport cyclique élevé selon la revendication 1, **caractérisé en ce que** le substrat de l'étape (1) est un matériau solide, et le matériau solide est constitué de produits électroniques, de composants électriques, de produits semi-finis électroniques assemblés, de circuits imprimés, de plaques métalliques, de plaques de téflon ou de pièces et composants électroniques, et lorsque la surface de substrat est dotée du nano-revêtement multifonctionnel pour la protection, l'une des surfaces est utilisée en exposition à un environnement d'eau, aux champignons, aux solvants acides ou alcalins, au brouillard salin acide ou alcalin, à une atmosphère acide, à l'immersion dans des solvants organiques, cosmétiques, à la transpiration, à l'impact de cycles thermiques ou à l'alternance d'humidité et de chaleur.

4. Procédé de préparation cyclique d'un nano-revêtement multifonctionnel pour la protection au moyen de la décharge à impulsion à rapport cyclique élevé selon la revendication 1, **caractérisé en ce que** l'étape (2) d'envoi de la vapeur de monomère comporte l'atomisation et la volatilisation d'un monomère à travers une pompe d'alimentation, et l'introduction du monomère vers la chambre de réaction par une basse pression de 10 à 200 millitorrs, un flux entrant du monomère étant de 10 à 1 000 µL/min.

5. Procédé de préparation cyclique d'un nano-revêtement protecteur multifonctionnel au moyen d'une décharge d'impulsion à rapport cyclique élevé selon la revendication 1, **caractérisé en ce que** dans les étapes (3) et (4), un mode de décharge plasma est une décharge radiofréquence, une décharge micro-ondes, une décharge à fréquence intermédiaire, une décharge à haute fréquence ou une décharge par étincelle, et les formes d'onde de décharge à fréquence élevée et de décharge à fréquence intermédiaire sont des impulsions sinusoïdales ou bipolaires.
